# EUROPÄISCHE PATENTSCHRIFT

(11) **EP 1 911 104 B1**
(45) Veröffentlichungstag und Bekanntmachung des Hinweises auf die Patenterteilung: **15.05.2019**
(21) Anmeldenummer: 06775806.0
(22) Anmeldetag: 04.08.2006
(51) Int. Cl.: H01L 33/00, H01L 23/00, H01L 21/683, H01L 33/54, H01L 33/62

(54) **VERFAHREN ZUR HERSTELLUNG VON HALBLEITERBAUELEMENTEN UND DÜNNFILM-HALBLEITERBAUELEMENT**
METHOD FOR PRODUCING SEMICONDUCTOR COMPONENTS AND THIN-FILM SEMICONDUCTOR COMPONENT
PROCÉDÉ DE PRODUCTION DE COMPOSANTS SEMI-CONDUCTEURS ET COMPOSANT SEMI-CONDUCTEUR À FILMS MINCES

(30) Priorität: 05.08.2005 DE 102005037023; 21.11.2005 DE 102005055293
(43) Veröffentlichungstag der Anmeldung: 16.04.2008
(73) Patentinhaber: OSRAM Opto Semiconductors GmbH, 93055 Regensburg (DE)
(72) Erfinder: HERRMANN, Siegfried, 94362 Neukirchen (DE); HAHN, Berthold, 93155 Hemau (DE)
(74) Vertreter: Epping - Hermann - Fischer
(86) Internationale Anmeldenummer: PCT/DE2006/001367
(87) Internationale Veröffentlichungsnummer: WO 2007/016908

(56) Entgegenhaltungen:
- EP-A- 1 351 308
- WO-A2-2004/068572
- US-A- 6 071 795
- US-A1- 2005 148 106
- US-B1- 6 562 648

## Beschreibung

Die Erfindung betrifft ein Verfahren zur Herstellung von Halbleiterbauelementen und ein Dünnfilm-Halbleiterbauelement. Die Druckschriften US 2005/0148106 A1, WO 2004/068572 A2, EP 1351308 A und US 6071795 A beschreiben jeweils ein Verfahren zur Herstellung von Halbleiterbauelementen und ein Dünnfilm-Halbleiterbauelement.

Eine Aufgabe der vorliegenden Erfindung ist es, ein vereinfachtes Verfahren zur Herstellung von Halbleiterbauelementen anzugeben. Weiterhin ist es Aufgabe der vorliegenden Erfindung, ein Dünnfilm-Halbleiterbauelement anzugeben, das leicht handhabbar und mechanisch stabil ist.

Diese Aufgaben werden durch ein Verfahren und ein Dünnfilm-Halbleiterbauelement gemäß der beiden unabhängigen Patentansprüche 1 und 21 gelöst. Vorteilhafte Weiterbildungen der Verfahren und der Dünnfilm-Halbleiterbauelemente sind in den abhängigen Ansprüchen angegeben.

Die folgende Offenbarung enthält Ausführungsformen, Ausführungsbeispiele und Varianten, von denen einige gemäß der Erfindung sind. Die Erfindung ist durch die beigefügten Patentansprüche 1-42 definiert.

Eine erste Variante eines Verfahrens zur Herstellung von Halbleiterbauelementen umfasst folgende Schritte:
- Ausbilden eines ein Halbleitermaterial enthaltenden Schichtenverbunds auf einem Aufwachssubstrat,
- Aufbringen einer flexiblen Trägerschicht auf den Schichtenverbund,
- Aushärten der flexiblen Trägerschicht zu einer selbsttragenden Trägerschicht,
- Ablösen des Aufwachssubstrats.

Es wird also auf der dem Aufwachssubstrat abgewandten Seite des Schichtenverbunds eine flexible Trägerschicht aufgebracht, die dem Schichtenverbund nach dem Aushärten als selbsttragende, vorzugsweise starre Trägerschicht anhaftet.

Eine zweite Variante eines Verfahrens zur Herstellung von Halbleiterbauelementen umfasst folgende Schritte:
- Ausbilden eines ein Halbleitermaterial enthaltenden Schichtenverbunds auf einem Aufwachssubstrat,
- Aufbringen einer selbsttragenden Trägerschicht auf den Schichtenverbund, wobei die Trägerschicht eine Grundschicht und eine dem Schichtenverbund zugewandte Haftschicht aufweist, die auf dem Schichtenverbund haftet,
- Ablösen des Aufwachssubstrats.

Es wird also auf der dem Aufwachssubstrat abgewandten Seite des Schichtenverbunds eine Trägerschicht aufgebracht, die dem Schichtenverbund im fertigen Halbleiterbauelement als selbsttragende, vorzugsweise starre Trägerschicht anhaftet.

Vorteilhafterweise kann eine gesonderte Verbindung zwischen dem Schichtenverbund und der Trägerschicht, etwa eine Lötverbindung, und dadurch ein Kosten verursachender Verfahrensschritt, das Bonden, eingespart werden.

Gemäß der ersten Variante hat die selbsttragende Trägerschicht gegenüber der flexiblen Trägerschicht den Vorteil, dass sie gestaltfester und daher leichter handhabbar ist.

Bei der zweiten Variante kann die Haftschicht aus einem Schmelzklebstoff und die Grundschicht aus einem formstabilen Kunststoff gebildet sein. Hierbei ist eine Erwärmung der Haftschicht erforderlich, um diese aufzuschmelzen und eine ausreichende Benetzung des Schichtenverbunds und somit nach dem Aushärten eine ausreichende Haftung zu erzielen. Bei Raumtemperatur ist die Haftschicht vorzugsweise fest. Ferner ist es denkbar, dass die Haftschicht ohne zusätzliche Erwärmung auf dem Schichtenverbund haftet. In diesem Fall kann die Haftschicht beispielsweise Silikon und die Grundschicht Polyimid enthalten.

Bei einer bevorzugten Ausführungsform der zweiten Variante des Verfahrens enthält die Grundschicht ein Kunststoffmaterial. Als Alternative kann die Grundschicht Glas enthalten.

Bevorzugter Weise ist die Trägerschicht eine Folie. Insbesondere kann die Trägerschicht ein in Bahnen hergestelltes Kunststoffblatt sein. Eine ausreichende Stabilität kann auch bei einer relativ geringen Dicke der erfindungsgemäßen Trägerschicht erreicht werden. Denn aufgrund der relativ geringen Dicke ist die Trägerschicht elastisch, wodurch die Gefahr von Rissbildungen reduziert ist. Unter einer relativ geringen Dicke sind dabei bevorzugt 100 µm, besonders bevorzugt weniger als 100 µm zu verstehen.

Besonders bevorzugter Weise ist die Trägerschicht transparent. Dies hat den Vorteil, dass die Trägerschicht gleichzeitig als Auskoppelschicht dienen kann.

Mit dem erfindungsgemäßen Verfahren werden vorzugsweise Dünnfilm-Halbleiterbauelemente, insbesondere strahlungsemittierende Dünnfilm-Halbleiterbauelemente, hergestellt.

Ein strahlungsemittierendes Dünnfilm-Halbleiterbauelement zeichnet sich insbesondere durch mindestens eines der folgenden charakteristischen Merkmale aus:
- an einer zu einem Trägerelement hin gewandten ersten Hauptfläche einer strahlungserzeugenden Epitaxieschichtenfolge ist vorzugsweise eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20 µm oder weniger, insbesondere im Bereich von 10 µm auf; und
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines strahlungsemittierenden Dünnschicht-Halbleiterbauelements ist beispielsweise in I. Schnitzer et al., Appl. Phys. Lett. 63 (16), 18. Oktober 1993, 2174 - 2176 beschrieben.

Ein derartiges strahlungsemittierendes Dünnfilm-Halbleiterbauelement ist in guter Näherung ein Lambert'scher Oberflächenstrahler.

Bei der Erfindung weist der Schichtenverbund demnach eine aktive Schichtenfolge zur Erzeugung von elektromagnetischer Strahlung auf, die vorzugsweise epitaktisch auf dem Aufwachssubstrat aufgewachsen ist.

Zur Herstellung einer Mehrzahl von Dünnfilm-Halbleiterbauelementen wird der Schichtenverbund in einzelne Schichtenstapel strukturiert. Diese können beispielsweise durch Sägen vereinzelt werden.

Die Trägerschicht kann vorstrukturiert auf den Schichtenverbund aufgebracht werden, so dass der Schichtenverbund entlang der Struktur in Schichtenstapel vereinzelbar ist.

Bei einer bevorzugten Ausführungsform der ersten Variante des Verfahrens wird eine Trägerschicht verwendet, die ein Kunststoffmaterial aufweist. Eine derartige Trägerschicht enthält besonders bevorzugt ein Epoxidharz, PET (Polyethylenterephthalat) oder ein Polymer, insbesondere ein Polyimid, beispielsweise Kapton, oder eine Kombination dieser Materialien. Kapton ist der Markenname der von der Firma DuPont angebotenen Poliyimid-Produkte.

Bei einem herkömmlichen Verfahren werden beim Bonden des Schichtenverbunds auf den Trägerkörper typischerweise Temperaturen im Bereich von 400 °C erreicht. Beim anschließenden Abkühlen auf Zimmertemperatur kann eine Verspannung beziehungsweise Verbiegung auftreten, wenn die thermischen Ausdehnungskoeffizienten des Aufwachssubstrats und des Trägerkörpers stark voneinander abweichen. Ferner können dadurch Risse im Trägerkörper auftreten, so dass das entstehende Bauelement keine ausreichende Stabilität mehr aufweist.

Da das erfindungsgemäße Verfahren mit geringeren Temperaturen auskommt, treten geringere thermische Verspannungen auf, wodurch die Gefahr von Rissbildungen vorteilhafterweise reduziert ist.

Beispielsweise wird eine Trägerschicht, die ein silbergefülltes Epoxidharz enthält, bei 80 °C bis 90 °C aufgeschmolzen und bei einer Temperatur von 150 °C ausgehärtet, wobei eine Abweichung von 10% tolerabel ist.

Eine andere Möglichkeit für eine erfindungsgemäße Trägerschicht ist ein mit Glaspartikeln gefüllter Klebstofffilm. Dieser kann aus einem Hybridmaterial gebildet sein, das insbesondere ein Epoxidharz und ein Acrylat enthält. In das Hybridmaterial sind Glaspartikel mit einem Silber-Überzug eingelagert, wobei der Klebstofffilm vorteilhafterweise mittels der Glaspartikel elektrisch leitend ist. Der Klebstofffilm kann bei 120 °C aufgeschmolzen und bei 160 °C 30 Minuten lang ausgehärtet werden.

Um bei einem entsprechend dem erfindungsgemäßen Verfahren hergestellten Halbleiterbauelement die im Betrieb entstehende Verlustwärme abführen zu können, wird die Trägerschicht vorzugsweise thermisch leitend ausgebildet. Dadurch können unerwünschte Effekte wie eine Verschiebung der Wellenlänge oder eine Intensitätsminderung der von dem Halbleiterbauelement emittierten Strahlung vermieden werden.

Bei einer bevorzugten Ausführungsform eines erfindungsgemäßen Verfahrens wird die Trägerschicht mit einem elektrisch isolierenden Material ausgebildet. Auf die Trägerschicht kann zumindest eine elektrische Leiterbahn aufgebracht werden, um später eine Anordnung aus auf einer gemeinsamen Trägerschicht aufgebrachten Schichtstapel oder ein vereinzeltes Bauelement mit einer Elektrode zu verbinden.

Alternativ kann die Trägerschicht mit einem elektrisch leitfähigen Material ausgebildet werden. Beispielsweise enthält die Trägerschicht ein Metall, insbesondere Al, Ag, Ti, Cu, oder eine Legierung, insbesondere Messing.

Für eine elektrische Kontaktierung von Halbleiterbauelementen wird der Schichtenverbund auf der der Trägerschicht zugewandten Seite mit einer Kontaktfläche versehen, insbesondere einer Kontaktmetallisierung, diese ein Metall enthält.

Bei einer bevorzugten Ausführungsform des erfindungsgemäßen Verfahrens wird für die Kontaktmetallisierung ein Material gewählt, das die in einem späteren Betrieb von einem aktiven Schichtenstapel erzeugte Strahlung zumindest teilweise reflektiert. Dies ist vor allem dann vorteilhaft, wenn die Trägerschicht für die erzeugte Strahlung nicht durchlässig ist und die Strahlung auf der der Trägerschicht gegenüberliegenden Seite des Halbleiterbauelements ausgekoppelt wird.

Das Aufwachssubstrat wird vorzugsweise durch ein Laserablöseverfahren entfernt, wie es beispielsweise aus der WO 98/14986 bekannt ist. Das Aufwachssubstrat kann auch durch andere Verfahren wie Plasma- oder Trockenätzen abgelöst oder mechanisch entfernt werden.

Nach dem Ablösen des Aufwachssubstrats wird auf der der Trägerschicht abgewandten Seite des Schichtenverbunds eine zweite Kontaktfläche, nämlich eine Kontaktmetallisierung aufgebracht, die für eine weitere elektrische Kontaktierung der späteren Dünnfilm-Halbleiterbauelemente vorgesehen ist.

Außerdem wird auf der der Trägerschicht abgewandten Seite des Schichtenstapels eine flexible Abdeckschicht aufgebracht, die ausgehärtet werden kann. Alternativ kann die flexible Abdeckschicht in einem nicht vollständig ausgehärteten Zustand belassen werden.

Eine weitere Möglichkeit besteht darin, eine Abdeckschicht aufzubringen, die eine Grundschicht und eine dem Schichtenverbund zugewandte Haftschicht aufweist, wobei die Haftschicht auf dem Schichtenverbund haftet.

Die Abdeckschicht ist erfindungsgemäß eine Folie.

Vorzugsweise ist die Abdeckschicht für die von der aktiven Schicht erzeugte Strahlung durchlässig. Bei einer vorteilhaften Ausführungsform enthält die Abdeckschicht ein Konvertermaterial zur anteiligen Wellenlängenkonversion der von dem späteren aktiven Schichtenstapel erzeugten Strahlung.

Die Abdeckschicht weist besonders bevorzugt der Trägerschicht entsprechende Eigenschaften auf. Sie kann aber auch ein von der Trägerschicht verschiedenes Material enthalten.

Gemäß einer bevorzugten Variante ist die Abdeckschicht aus Glas gebildet. Weiterhin kann die Abdeckschicht auf einer dem Schichtenverbund zugewandten Seite zur oberseitigen Kontaktierung des Dünnfilm-Halbleiterbauelements zumindest eine Leiterbahn aufweisen, die insbesondere ein strahlungsdurchlässiges Material wie ITO (Indium Tin Oxide) enthält.

Vorteilhafterweise kann eine beidseitige Anordnung der Trägerschicht und der Abdeckschicht einen Gehäusekörper ersetzen.

Ein Dünnfilm-Halbleiterbauelement gemäß einer ersten Variante, das vorzugsweise entsprechend der ersten Variante des Verfahrens herstellbar ist, weist folgende Bestandteile auf:
- einen Schichtenstapel,
- eine selbsttragende, vorzugsweise starre Trägerschicht, die auf dem Schichtenstapel angeordnet ist, wobei die Trägerschicht ausgehärtet ist.

Ein Dünnfilm-Halbleiterbauelement gemäß einer zweiten Variante, der vorzugsweise entsprechend der zweiten Variante des Verfahrens herstellbar ist, weist folgende Bestandteile auf:
- einen Schichtenstapel,
- eine selbsttragende Trägerschicht, die auf dem Schichtenstapel angeordnet ist, wobei die Trägerschicht eine Grundschicht und eine dem Schichtenstapel zugewandte Haftschicht aufweist, die auf dem Schichtenstapel haftet. Insbesondere weist die Trägerschicht die Eigenschaften auf, die bereits im Zusammenhang mit der ersten und zweiten Variante des Verfahrens erwähnt wurden.

Da bei einem Dünnfilm-Halbleiterbauelement mit einer erfindungsgemäßen Trägerschicht eine ausreichende mechanische Stabilität vorhanden ist, wird kein zusätzlicher Träger benötigt. Somit kann das Halbleiterbauelement mit einer vorteilhaft geringen Bauhöhe, beispielsweise 120 µm, ausgeführt werden.

Das Dünnfilm-Halbleiterbauelement ist zur Erzeugung elektromagnetischer Strahlung vorgesehen und weist dafür einen aktiven Schichtenstapel auf, der Teil des Schichtenstapels ist. Beispielsweise kann der aktive Schichtenstapel einen herkömmlichen pn-Übergang, eine Doppelheterostruktur, eine Einfach-Quantentopfstruktur oder eine Mehrfach-Quantentopfstruktur aufweisen.

Weiterhin weist das Dünnfilm-Halbleiterbauelement bei einer bevorzugten Ausführungsform einen Nitrid-Verbindungshalbleiter auf, was bedeutet, dass der aktive Schichtenstapel oder zumindest eine Schicht davon ein Nitrid-III/V-Verbindungshalbleitermaterial, vorzugsweise AlₙGaₘIn₁₋ₙ₋ₘN umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des AlₙGaₘIn₁₋ₙ₋ₘN-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe, beispielsweise P, ersetzt sein können.

Ein Dünnfilm-Halbleiterbauelement, das einen Nitrid-Verbindungshalbleiter aufweist, emittiert hauptsächlich Strahlung mit einer Wellenlänge im kurzwelligen Bereich des sichtbaren optischen Spektrums.

Die Wellenlänge kann mittels eines Konverterelements, das dem Schichtenstapel in Abstrahlrichtung nachgeordnet ist, zumindest teilweise in eine längere Wellenlänge umgewandelt werden.

Insbesondere kann ein Konvertermaterial in das Dünnfilm-Halbleiterbauelement, vorzugsweise in der Abdeckschicht, integriert sein.

Erfindungsgemäß kann die Trägerschicht ein Kunststoffmaterial enthalten. Für die Trägerschicht bevorzugte Materialien sind beispielsweise ein Epoxidharz, PET, ein Polymer, insbesondere Polyimid, beispielsweise Kapton, oder eine Kombination dieser Materialien.

Ferner kann die Trägerschicht beziehungsweise die Abdeckschicht jede der im Zusammenhang mit dem erfindungsgemäßen Verfahren genannten Eigenschaften aufweisen. Entsprechendes gilt für das Dünnfilm-Halbleiterbauelement.

Darüber hinaus enthält die Trägerschicht bei einer bevorzugten Ausführungsform Kohlefasern. Diese können beispielsweise in einen Polymerfilm eingebettet sein und eine höhere thermische Leitfähigkeit aufweisen als der Polymerfilm, so dass sich daraus vorteilhafterweise insgesamt eine haftende und thermisch leitende Trägerschicht ergibt.

Außerdem kann die Trägerschicht ein Glasgewebe, insbesondere ein Silikat, aufweisen.

Bei einer weiteren bevorzugten Ausführungsform ist die Trägerschicht für die von dem aktiven Schichtenstapel erzeugte Strahlung durchlässig. Dies hat den Vorteil, dass die Strahlung direkt auskoppeln kann und Strahlungsverluste, die durch Absorption von reflektierter Strahlung in dem aktiven Schichtenstapel auftreten können, reduziert sind.

Es ist denkbar, dass auf der der Trägerschicht abgewandten Seite die Abdeckschicht aufgebracht ist, die im nicht vollständig ausgehärteten Zustand belassen sein kann, bevorzugter Weise jedoch selbsttragend, insbesondere starr ausgebildet ist und der Trägerschicht entsprechende Eigenschaften aufweist.

Bei einer vorteilhaften Ausführungsform enthält die Abdeckschicht ein Konvertermaterial zur anteiligen Wellenlängenkonversion der von dem aktiven Schichtenstapel erzeugten Strahlung. Weiterhin kann die Abdeckschicht eine optische Struktur aufweisen. Die optische Struktur kann auf eine dem Schichtenstapel zugewandten oder abgewandten Seite der Abdeckschicht vorgesehen sein. Vorteilhafterweise kann mittels der optischen Struktur die Abstrahlcharakteristik der im Dünnfilm-Halbleiterbauelement erzeugten Strahlung beeinflusst werden. Beispielsweise kann die optische Struktur linsen-, prismen oder pyramidenförmig ausgebildet sein.

Da der Schichtenstapel typischerweise eine Höhe im Bereich von 20 µm beziehungsweise von 10 µm aufweist, können die Trägerschicht und die Abdeckschicht, deren Dicke besonders bevorzugt kleiner oder gleich 100 µm ist, den Schichtenstapel umschließen. Dies hat den Vorteil, dass kein weiterer Gehäusekörper notwendig ist.

Gemäß einer bevorzugten Ausführungsform ist zwischen der Trägerschicht und der Abdeckschicht eine Füllschicht angeordnet. Die Füllschicht kann beispielsweise ein Kunststoffmaterial enthalten.

Ferner kann das Dünnfilm-Halbleiterbauelement in einen Gehäusekörper eingebaut werden.

Bei einer besonderen Ausführungsform sind sowohl die Trägerschicht als auch die Abdeckchicht für die von dem aktiven Schichtenstapel erzeugte Strahlung durchlässig, was zu einem doppelseitig emittierenden Dünnfilm-Halbleiterbauelement führt.

Weitere Merkmale und vorteilhafte Ausgestaltungen des Verfahrens beziehungsweise des Dünnfilm-Halbleiterbauelements ergeben sich aus den im Folgenden in Verbindung mit den Figuren 1a bis 1f, 2 und 3 näher erläuterten Ausführungsbeispielen.

Es zeigen:
Figuren 1a bis 1f eine schematische Darstellung eines ersten Ausführungsbeispiels eines Verfahrens anhand von sechs Herstellungsschritten,
Figur 2 eine schematische, perspektivische Darstellung eines ersten Ausführungsbeispiels der Dünnfilm-Halbleiterbauelemente,
Figur 3 eine schematische, perspektivische Darstellung eines Ausführungsbeispiels eines erfindungsgemäßen Dünnfilm -Halbleiterbauelements,
Figur 4 eine schematische Schnittansicht eines Dünnfilm-Halbleiterbauelements gemäß dem ersten Ausführungsbeispiel, das in einem Gehäusekörper angeordnet ist,
Figuren 5a bis 5d eine schematische Darstellung eines zweiten Ausführungsbeispiels eines Verfahrens anhand von vier Herstellungsschritten.

In den Ausführungsbeispielen sind gleiche oder gleichwirkende Bestandteile jeweils mit den gleichen Bezugszeichen versehen. Die dargestellten Bestandteile der Figuren, insbesondere die Größen von dargestellten Schichtdicken, sind grundsätzlich nicht als maßstabsgerecht anzusehen. Vielmehr können sie zum besseren Verständnis teilweise übertrieben groß dargestellt sein.

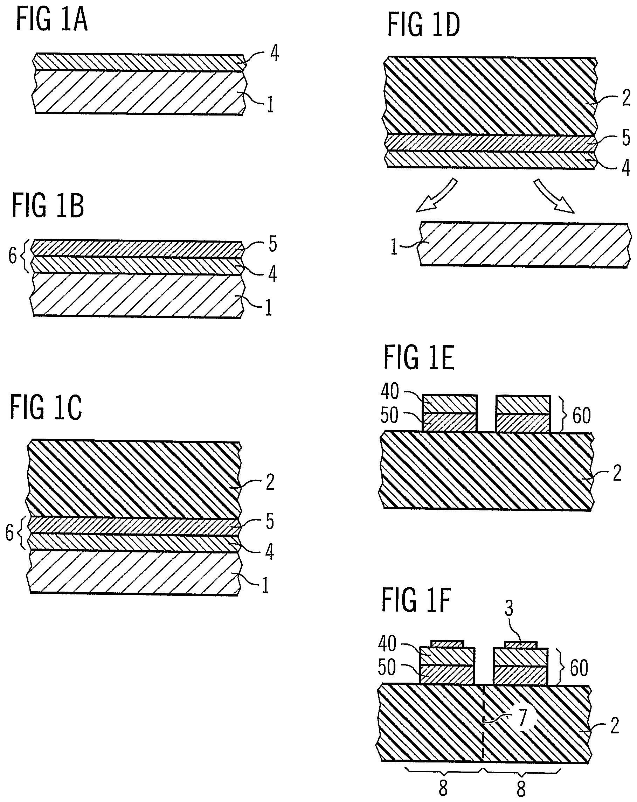

In den Figuren 1a bis 1f ist jeweils ein Herstellungsschritt eines ersten Ausführungsbeispiels eines Verfahrens dargestellt.

Bei einem in Figur 1a dargestellten ersten Herstellungsschritt wird eine aktive Schichtenfolge 4 auf einem Aufwachssubstrat 1 aufgebracht. Dies kann beispielsweise durch epitaktisches Aufwachsen mehrer unterschiedlicher Schichten, die vorzugsweise einen Nitrid-Verbindungshalbleiter gemäß der oben genannten Definition enthalten, auf einem Saphir- oder SiC-Substrat erfolgen. Die so hergestellte aktive Schichtenfolge 4 ist vorzugsweise zur Erzeugung elektromagnetischer Strahlung geeignet. Ihre Struktur ist entsprechend einer der oben genannten Möglichkeiten gestaltet.

In Figur 1b ist ein zweiter Herstellungsschritt dargestellt, bei dem auf der aktiven Schichtenfolge 4 eine Kontaktmetallisierung 5 aufgebracht wird. Zusammen bilden die aktive Schichtenfolge 4 und die Kontaktmetallisierung 5 den Schichtenverbund 6. Die Kontaktmetallisierung 5 ist elektrisch leitfähig und reflektiert außerdem bei einem späteren Betrieb eines u. a. aus dem Schichtenverbund gebildeten Bauelements die von einem aktiven Schichtenstapel 40 emittierte Strahlung.

Die Kontaktmetallisierung 5 kann auf der aktiven Schichtenfolge 4 ganzflächig aufgebracht sein. Alternativ kann die Kontaktmetallisierung 5 partiell an den Stellen, zum Beispiel durch eine Maske, aufgebracht sein, an denen später Schichtenstapel ausgebildet werden.

Vorzugsweise enthält die Kontaktmetallisierung 5 ein metallisches Material wie Ag, Al oder Au, das beispielsweise aufgedampft wird. Weiterhin können Schichten mit integrierten elektrischen Kontakten und verschiedenen Dielektrizitätskonstanten, die einen Bragg-Spiegel bilden, auf der aktiven Schichtenfolge 4 angeordnet werden.

Die Kontaktmetallisierung 5 kann bei einem späteren Bauelement gleichzeitig einen rückseitigen elektrischen Kontakt bilden.

Bei einem in Figur 1c dargestellten dritten Herstellungsschritt wird auf dem Schichtenverbund 6 zunächst eine gemeinsame flexible Trägerschicht 2 angeordnet, die anschließend zu einer starren, selbsttragenden Trägerschicht 2 ausgehärtet wird. Die Dicke der Trägerschicht 2 wird vorzugsweise im Bereich von 100 µm gewählt. Beispielsweise wird für die Trägerschicht 2 ein silbergefüllter Epoxidklebstofffilm verwendet, der 80% Silber und 20% nicht flüchtiges Epoxidharz enthält. Der silbergefüllte Epoxidklebstofffilm wird auf den Schichtenverbund 6 aufgebracht und anschließend auf 80 °C bis 90 °C erhitzt. Dabei wird der Klebstofffilm leicht aufgeschmolzen, wodurch er eine gute Primärhaftung erhält. Nachfolgend wird der Film bei Temperaturen von ungefähr 150 °C ausgehärtet. Die so entstandene Trägerschicht 2 ist elektrisch leitfähig und weist eine Glasübergangstemperatur von 150 bis 155 °C auf. Ferner ist die Trägerschicht 2 thermisch und chemisch beständig.

Für die Trägerschicht 2 kann insbesondere jedes andere Material, vorzugsweise ein Kunststoffmaterial, verwendet werden, das Eigenschaften aufweist, die den beispielhaft anhand des Epoxidklebstofffilms verdeutlichten Eigenschaften entsprechen.

Bei einer weiteren Variante umfasst die Trägerschicht 2 einen gefüllten Klebstofffilm. Dieser ist aus einem Hybridmaterial gebildet, das ein Epoxidharz und ein Acrylat enthält. In das Hybridmaterial sind Glaspartikel mit einem Silber-Überzug eingebettet, wobei der Klebstofffilm vorteilhafterweise mittels der Glaspartikel elektrisch leitend ist. Der Klebstofffilm kann bei 120 °C aufgeschmolzen und bei 160 °C 30 Minuten lang ausgehärtet werden.

In Figur 1d ist ein vierter Herstellungsschritt dargestellt, bei dem das Aufwachssubstrat 1 vom Schichtenverbund 6 abgelöst wird. Die Ablösung kann mittels eines Laserablöseverfahrens erfolgen, wie es beispielsweise aus der WO 98/14986 bekannt ist. Alternativ kann die Ablösung durch Ätzen oder ein sonstiges geeignetes Abhebeverfahren erfolgen.

Im Wesentlichen wird bei einem Laserablöseverfahren durch das Aufwachssubstrat 1 hindurch eine Grenzfläche zwischen dem Aufwachssubstrat 1 und der aktiven Schichtenfolge 4 mit elektromagnetischer Strahlung, vorzugsweise Laserstrahlung, bestrahlt, so dass an der Grenzfläche durch Absorption der Strahlung eine Materialzersetzung stattfindet. Dadurch lassen sich das Aufwachssubstrat 1 und die aktive Schichtenfolge 4 im Wesentlichen zerstörungsfrei voneinander trennen. Somit kann das Aufwachssubstrat 1 weiter verwendet werden.

Bei einem in Figur 1e dargestellten fünften Herstellungsschritt werden aus dem Schichtenverbund 6 auf der Trägerschicht 2 voneinander getrennte Schichtenstapel 60 mit einem aktiven Schichtenstapel 40 und jeweils einer elektrisch leitfähigen Kontaktmetallisierung 50 gebildet. Dies erfolgt beispielsweise durch nasschemisches Ätzen oder Trockenätzen.

Alternativ kann der Schichtenverbund 6 bereits während des im Zusammenhang mit Figur 1b beschriebenen Herstellungsschrittes in einzelne Schichtenstapel 60 getrennt werden. Dies kann ebenfalls durch Ätzen, beispielsweise durch Plasmaätzen, erfolgen.

In Figur 1f ist ein sechster Herstellungsschritt dargestellt, bei dem auf die Schichtenstapel 60 eine zweite Kontaktmetallisierung 3 beispielsweise für eine oberseitige Kontaktierung der späteren Halbleiterbauelemente aufgebracht wird.

Die Schichtenstapel 60 können gemeinsam mit der Trägerschicht 2 entlang der Trennebene 7 durchtrennt, insbesondere zersägt, werden. Dadurch entstehen einzelne Halbleiterbauelemente 8, die einzeln in einem Gehäusekörper eingebaut werden können.

Gemäß der vorliegenden Erfindung kommt ein weiterer Herstellungsschritt hinzu, bei dem vor der Durchtrennung auf den Schichtenstapeln 60 auf der der Trägerschicht 2 gegenüberliegenden Seite eine flexible Abdeckschicht, die eine Folie ist, aufgebracht wird, die nachfolgend zu einer starren, selbsttragenden Abdeckschicht ausgehärtet werden kann oder alternativ in einem nicht vollständig ausgehärteten Zustand belassen werden kann.

Es sei darauf hingewiesen, dass das erfindungsgemäße Verfahren nicht auf die gemäß der Ausführungsform angegebene Reihenfolge festgelegt ist.

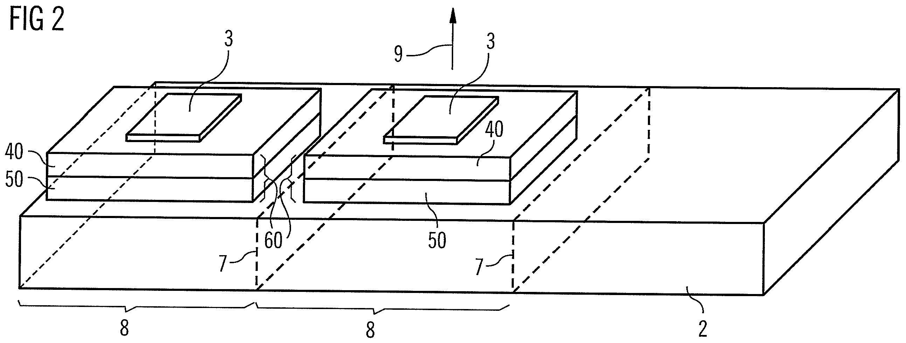

In Figur 2 sind Schichtenstapel 60 dargestellt, die vorzugsweise entsprechend dem oben Verfahren hergestellt sind.

Die Schichtenstapel 60 umfassen die Kontaktmetallisierung 50 und die aktiven Schichtenstapel 40. Die Höhe der Schichtenstapel 60 beträgt ungefähr 10 µm. Auf dem aktiven Schichtenstapel 40 ist die zweite Kontaktmetallisierung 3 aufgebracht. Die Schichtenstapel 60 sind auf der starren, selbsttragenden Trägerschicht 2 angeordnet, die ungefähr eine Dicke von 100 µm aufweist.

Gemäß einer ersten Ausführungsform liegen die Halbleiterbauelemente 8 vereinzelt, entlang der Trennebene 7 durchtrennt vor. Als einzelne Halbleiterbauelemente können sie beispielsweise in einem Gehäusekörper eingebaut sein. Da die Trägerschicht 2 starr, selbsttragend und ausreichend stabil ausgebildet ist, sind die Halbleiterbauelemente 8 leicht handhabbar, ohne dass ein zusätzlicher Hilfsträger zur Weiterbearbeitung notwendig ist.

Ferner ist die Trägerschicht 2 vorzugsweise elektrisch leitend ausgebildet, so dass das Halbleiterbauelement 8 rückseitig über die Trägerschicht 2 an eine erste Elektrode anschließbar ist. Über die zweite Kontaktmetallisierung 3 ist das Halbleiterbauelement 8 oberseitig an eine zweite Elektrode anschließbar. Weiterhin ist die Kontaktmetallisierung 50 elektrisch leitfähig und reflektiert die von dem aktiven Schichtenstapel 40 erzeugte Strahlung. Dadurch lässt sich die Strahlungsausbeute in der Abstrahlrichtung 9 erhöhen.

Gemäß einer zweiten Ausführungsform ist die Trägerschicht 2 nicht durchtrennt. Vielmehr bilden die auf der Trägerschicht 2 angeordneten Schichtenstapel 60 eine Matrix. Die Trägerschicht 2 kann beispielsweise elektrisch leitfähig sein. Alternativ kann die Trägerschicht 2 elektrisch isolierend sein und separat aufgebrachte Leiterbahnen aufweisen. Diese Leiterbahnen können die Schichtenstapel 60 in beliebiger, vorbestimmter Weise miteinander verbinden.

Eine derartige Matrixanordnung kann beispielsweise für ein Display oder eine Display-Hinterleuchtung verwendet werden.

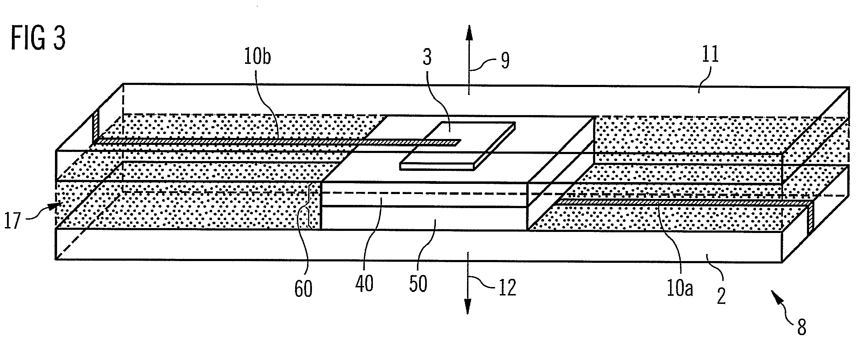

In Figur 3 ist ein erfindungsgemäßes Halbleiterbauelement 8 dargestellt, das den auf der Trägerschicht 2 angeordneten Schichtenstapel 60 mit der darauf aufgebrachten zweiten Kontaktmetallisierung 3 aufweist.

Bei diesem Ausführungsbeispiel ist die Kontaktmetallisierung 50 elektrisch leitfähig und für die von dem aktiven Schichtenstapel 40 erzeugte Strahlung durchlässig. Ferner ist die Trägerschicht 2 elektrisch isolierend und für die von dem aktiven Schichtenstapel 40 erzeugte Strahlung durchlässig.

Auf der der Trägerschicht 2 gegenüberliegenden Seite des Halbleiterbauelements 8 ist eine Abeckschicht 11 angeordnet. Die Abdeckschicht 11 ist wie die Trägerschicht 2 elektrisch isolierend und für die von dem aktiven Schichtenstapel 40 erzeugte Strahlung durchlässig. Somit emittiert das Dünnfilm-Halbleiterbauelement 8 sowohl in Abstrahlrichtung 9 als auch in Abstrahlrichtung 12. Die Abdeckschicht 11 sowie die Trägerschicht 2 können eine optische Struktur, wie bereits oben erwähnt, aufweisen.

Vorzugsweise enthalten die beiden Schichten 2 und 11 ein Kunststoffmaterial.

Die Trägerschicht 2 und die Abdeckschicht 11 weisen Leiterbahnen 10a, 10b auf, die das Dünnfilm-Halbleiterbauelement 8 mit einer Spannungsversorgung verbinden. Die Trägerschicht 2 und die Abdeckschicht 11 können vor dem Aufbringen auf den Schichtenstapel 60 mit den Leiterbahnen 10a, 10b versehen werden. Zwischen der Trägerschicht 2 und der Abdeckschicht 11 kann eine Füllschicht 17 angeordnet sein. Vorzugsweise enthält die Füllschicht 17 ein elektrisch isolierendes Material, so dass ein Kurzschluss zwischen der Trägerschicht 2 und der Abdeckschicht 11 verhindert wird.

Das dargestellte Dünnfilm-Halbleiterbauelement 8 weist eine ausreichende mechanische Stabilität auf, so dass auf einen weiteren Einbau in einen Gehäusekörper verzichtet werden kann. Denn aufgrund der geringen Höhe (ca. 10 µm) des Schichtenstapels 60 im Vergleich zur Dicke der Trägerschicht 2 und der flexiblen Abdeckschicht 11 (ca. 100 µm) ist der Schichtenstapel 60 von den beiden Schichten 2 und 11 quasi umschlossen.

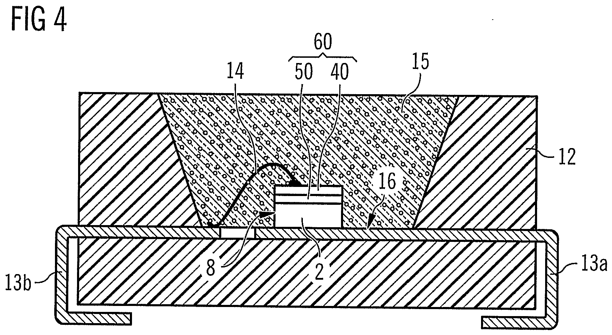

Das in Figur 4 gezeigte Dünnfilm-Halbleiterbauelement 8 ist in einem Gehäusekörper 12 angeordnet. Zur Montage des Halbleiterbauelements 8 wird die Trägerschicht 2 aufgeschmolzen und ausgehärtet. Nach dem Aushärten ist das Halbleiterelement 8 auf einer Montagefläche 16 fixiert. Die Trägerschicht 2 enthält mit Vorteil ein elektrisch leitendes Material wie im Zusammenhang mit der Figur 2 bereits beschrieben, so dass ein rückseitiger elektrischer Anschluss mittels der Trägerschicht 2 möglich ist. Die Montagefläche 16 ist vorzugsweise auf einem ersten Teil 13a eines Leiterrahmens vorgesehen, so dass das Dünnfilm-Halbleiterbauelement 8 rückseitig mittels des Leiterrahmens 13a elektrisch anschließbar ist. Oberseitig ist das Dünnfilm-Halbleiterbauelement 8 mittels eines elektrischen Leiters 14 mit einem zweiten Leiterrahmen 13b elektrisch verbunden. Das Dünnfilm-Halbleiterbauelement 8 ist in einen Verguss 15 eingebettet.

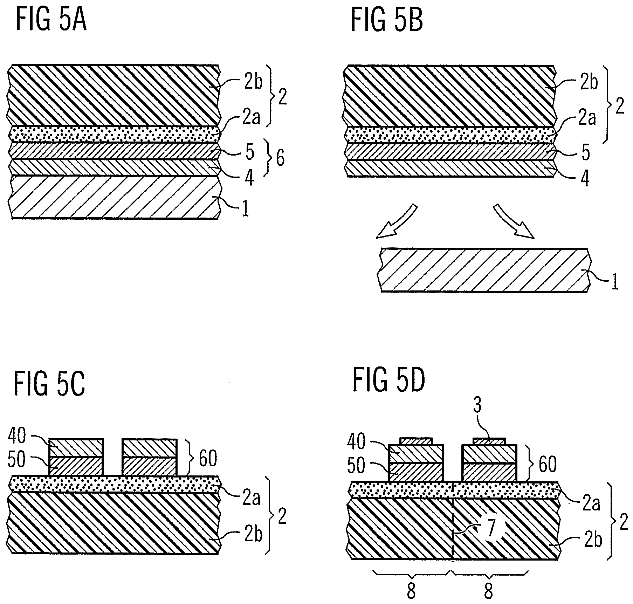

Das im Zusammenhang mit den Figuren 5a bis 5d beschriebene zweite Ausführungsbeispiel eines Verfahrens kann als erste Verfahrensschritte die bereits im Zusammenhang mit den Figuren 1a und 1b beschriebenen Verfahrensschritte aufweisen. Die nachfolgenden Schritte sind in den Figuren 5a bis 5d dargestellt. Diese werden im Wesentlichen in Analogie zu den in den Figuren 1c bis 1f dargestellten Schritten des ersten Ausführungsbeispiels durchgeführt. Der Unterschied besteht in der Trägerschicht 2, die im vorliegenden Fall zweiphasig ausgebildet ist. Die Trägerschicht 2 weist eine Grundschicht 2b und eine Haftschicht 2a auf.

Die Haftschicht 2a ist aus einem Klebstofffilm gebildet, der beispielsweise ein klebriges Silikonmaterial enthält. Die Haftschicht 2a ist auf der Grundschicht 2b angeordnet, die beispielsweise Polyimid enthält. Alternativ kann die Haftschicht 2a aus einem Schmelzklebstoff gebildet sein, wobei die Haftschicht 2a zunächst aufgeschmolzen und ausgehärtet wird, bevor sie am Schichtenverbund 6 haftet.

Die in der vorliegenden Anmeldung beschriebenen Halbleiterbauelemente können im weiteren Sinne auch als "Halbleiterchips" bezeichnet werden. Der Klarheit halber wurde vorliegend die neutralere Bezeichnung "Halbleiterbauelement" gewählt, um Verwechslungen mit dem ein Halbleitermaterial enthaltenden Schichtverbund, also etwa dem epitaktischen Halbleiterschichtstapel, zu vermeiden. Die Bezeichnung "Halbleiterbauelement" entspricht insbesondere der Bezeichnung "Halbleiterchip" der DE-Patentanmeldung 102005037023.3 und 102005055293.5, deren Priorität in Anspruch genommen wird.

Die Erfindung ist nicht durch die Beschreibung anhand der Ausführungsbeispiele beschränkt, sondern durch die beigefügten Patentansprüche definiert.

## Patentansprüche

1. Verfahren zur Herstellung von Halbleiterbauelementen (8) mit den Schritten:
- Ausbilden eines ein Halbleitermaterial enthaltenden Schichtenverbunds (6) auf einem Aufwachssubstrat (1),
- Aufbringen einer starren, selbsttragenden Trägerschicht (2) auf den Schichtenverbund (6), wobei die Trägerschicht durch Aufbringen einer flexiblen Schicht auf den Schichtenverbund (6) und Aushärten der flexiblen Schicht zu einer starren, selbsttragenden Schicht erzeugt wird, oder die Trägerschicht (2) eine Grundschicht (2b) und eine dem Schichtenverbund (6) zugewandte Haftschicht (2a) aufweist, die auf dem Schichtenverbund (6) haftet,
- Ablösen des Aufwachssubstrats (1) und anschließend Versehen des Schichtenverbundes (6) mit einer zweiten Kontaktmetallisierung (3),
- Aufbringen einer flexiblen Abdeckschicht (11), die eine Folie ist, auf die zweite Kontaktmetallisierung (3), wobei
- die Trägerschicht (2) und die Abdeckschicht (11) im fertigen Bauelement verbleiben.

2. Verfahren nach Anspruch 1, wobei
die Haftschicht (2a) aus einem Schmelzklebstoff gebildet ist.

3. Verfahren nach Anspruch 1 oder 2, wobei
die Grundschicht (2b) aus einem Kunststoffmaterial gebildet ist.

4. Verfahren nach einem der vorhergehenden Ansprüche, wobei die Trägerschicht (2) eine Folie ist.

5. Verfahren nach einem der vorhergehenden Ansprüche, wobei die Trägerschicht (2) transparent ist.

6. Verfahren nach einem der vorhergehenden Ansprüche, wobei die Halbleiterbauelemente (8) Dünnfilm-Halbleiterbauelemente sind.

7. Verfahren nach einem der vorhergehenden Ansprüche, wobei der Schichtenverbund (6) eine aktive Schichtenfolge (4) zur Erzeugung von elektromagnetischer Strahlung aufweist.

8. Verfahren nach einem der vorhergehenden Ansprüche, wobei der Schichtenverbund (6) in einzelne Schichtenstapel (60) strukturiert wird.

9. Verfahren nach einem der vorhergehenden Ansprüche, wobei die Trägerschicht (2) ein Kunststoffmaterial enthält.

10. Verfahren nach Anspruch 9, wobei
das Kunststoffmaterial ein Epoxidharz, Polyethylenterephthalat und/oder Polymer enthält.

11. Verfahren nach Anspruch 9 oder 10, wobei
das Kunststoffmaterial Härtungstemperaturen im Bereich von 150 °C aufweist.

12. Verfahren nach einem der vorhergehenden Ansprüche, wobei die Trägerschicht (2) eine Dicke aufweist, die kleiner oder gleich 100 µm ist.

13. Verfahren nach einem der vorhergehenden Ansprüche, wobei die Trägerschicht (2) ein thermisch leitfähiges Material enthält.

14. Verfahren nach einem der vorhergehenden Ansprüche, wobei die Trägerschicht (2) ein elektrisch isolierendes Material enthält.

15. Verfahren nach einem der vorhergehenden Ansprüche die Trägerschicht (2) zumindest eine elektrische Leiterbahn (10a) aufweist.

16. Verfahren nach einem der Ansprüche 1 bis 13, wobei die Trägerschicht (2) ein elektrisch leitfähiges Material aufweist.

17. Verfahren nach einem der vorhergehenden Ansprüche, wobei der Schichtenverbund (6) auf der der Trägerschicht (2) zugewandten Seite eine erste Kontaktmetallisierung (50) aufweist.

18. Verfahren nach Anspruch 17, wobei
die Kontaktmetallisierung (50) die von der aktiven Schichtenfolge (4) erzeugte Strahlung zumindest teilweise reflektiert.

19. Verfahren nach einem der vorhergehenden Ansprüche, wobei das Aufwachssubstrat (1) mittels eines Laserablöseverfahrens abgelöst wird.

20. Verfahren nach Anspruch 1, wobei
die flexible Abdeckschicht (11) teilweise oder vollständig ausgehärtet wird.

21. Dünnfilm-Halbleiterbauelement (8) mit
- einem Schichtenstapel (60),
- einer starren, selbsttragenden Trägerschicht (2), die auf dem Schichtenstapel (60) angeordnet ist,
- einer zweiten Kontaktmetallisierung (3) auf dem Schichtenstapel (60),
**gekennzeichnet durch**
- einer Abdeckschicht (11), die eine Folie ist und auf einer der Trägerschicht (2) abgewandten Seite des Schichtenstapels (60) auf der zweiten Kontaktmetallisierung (3) angeordnet ist.

22. Dünnfilm-Halbleiterbauelement (8) nach dem vorherigen Anspruch, wobei
die Trägerschicht (2) eine Grundschicht (2b) und eine dem Schichtenstapel (60) zugewandte Haftschicht (2a) aufweist, die auf dem Schichtenstapel (60) haftet.

23. Dünnfilm-Halbleiterbauelement (8) nach dem vorherigen Anspruch, wobei
die Haftschicht (2a) aus einem Schmelzklebstoff gebildet ist.

24. Dünnfilm-Halbleiterbauelement (8) nach einem der beiden vorherigen Ansprüche, wobei
die Grundschicht (2b) aus einem Kunststoffmaterial gebildet ist.

25. Dünnfilm-Halbleiterbauelement (8) nach einem der Ansprüche 21 bis 24, wobei
die Trägerschicht (2) eine Folie ist.

26. Dünnfilm-Halbleiterbauelement (8) nach einem der Ansprüche 21 bis 25, wobei
die Trägerschicht (2) transparent ist.

27. Dünnfilm-Halbleiterbauelement (8) nach einem der Ansprüche 21 bis 26, wobei
der Schichtenstapel (60) einen aktiven Schichtenstapel (40) zur Erzeugung elektromagnetischer Strahlung aufweist.

28. Dünnfilm-Halbleiterbauelement (8) nach einem der Ansprüche 21 bis 27, wobei
die Trägerschicht (2) ein Kunststoffmaterial enthält.

29. Dünnfilm-Halbleiterbauelement (8) nach dem vorherigen Anspruch, wobei
die Trägerschicht ein Epoxidharz, Polyethylenterephthalat und/oder Polyimid enthält.

30. Dünnfilm-Halbleiterbauelement (8) nach einem der Ansprüche 21 bis 29, wobei
die Trägerschicht (2) ein elektrisch isolierendes Material enthält.

31. Dünnfilm-Halbleiterbauelement (8) nach Anspruch 22 oder einem auf Anspruch 22 rückbezogenen Anspruch, wobei die Trägerschicht (2) zumindest eine elektrische Leiterbahn (10a) aufweist.

32. Dünnfilm-Halbleiterbauelement (8) nach einem der Ansprüche 21 bis 29, wobei
die Trägerschicht (2) ein elektrisch leitfähiges Material enthält.

33. Dünnfilm-Halbleiterbauelement (8) nach dem vorherigen Anspruch, wobei
die Trägerschicht (2) ein Metall, insbesondere Aluminium, Silber, Titan oder Kupfer, oder eine Legierung, insbesondere Messing, enthält.

34. Dünnfilm-Halbleiterbauelement (8) nach Anspruch 32, wobei die Trägerschicht (2) Kohlefasern enthält.

35. Dünnfilm-Halbleiterbauelement (8) nach einem der Ansprüche 21 bis 33, wobei
die Trägerschicht (2) ein Silikat enthält.

36. Dünnfilm-Halbleiterbauelement (8) nach einem der Ansprüche 21 bis 35, wobei
die Trägerschicht (2) eine Dicke aufweist, die kleiner oder gleich 100 µm ist.

37. Dünnfilm-Halbleiterbauelement (8) nach einem der Ansprüche 21 bis 36, wobei
die Abdeckschicht (11) eine optische Struktur aufweist.

38. Dünnfilm-Halbleiterbauelement (8) nach einem der Ansprüche 21 bis 37, wobei
die Abdeckschicht (11) ein Konvertermaterial enthält.

39. Dünnfilm-Halbleiterbauelement (8) nach einem der Ansprüche 21 bis 38, wobei
zwischen der Trägerschicht (2) und der Abdeckschicht (11) eine Füllschicht (17) angeordnet ist.

40. Dünnfilm-Halbleiterbauelement (8) nach einem der Ansprüche 21 bis 39, wobei
die Trägerschicht (2) und die Abdeckschicht (11) einen Gehäusekörper für das strahlungsemittierende Halbleiterbauelement (8) bilden.

41. Dünnfilm-Halbleiterbauelement (8) nach einem der Ansprüche 21 bis 40, wobei
die Abdeckschicht (11) für die von dem aktiven Schichtenstapel (40) erzeugte Strahlung durchlässig ist.

42. Dünnfilm-Halbleiterbauelement (8) nach dem vorherigen Anspruch, wobei
das Dünnfilm-Halbleiterbauelement (8) doppelseitig emittierend ist.

## Claims

1. Method of producing semiconductor components (8) comprising the steps of:
- forming a layer composite (6) containing a semiconductor material on a growth substrate (1),
- applying a rigid, self-supporting carrier layer (2) on the layer composite (6), wherein the carrier layer is formed by applying a flexible layer on the layer composite (6) and curing the flexible layer to form a rigid, self-supporting layer, or the carrier layer (2) has a base layer (2b) and an adhesion layer (2a), which faces towards the layer composite (6) and which adheres on the layer composite (6),
- stripping away the growth substrate (1) and subsequently providing the layer composite (6) with a second contact metallization (3),
- applying a flexible covering layer (11), which is a film, on the second contact metallization (3), wherein
- the carrier layer (2) and the covering layer (11) remain in the finished component.

2. Method according to claim 1, wherein
the adhesion layer (2a) is formed from a hot melt adhesive.

3. Method according to claim 1 or 2, wherein
the base layer (2b) is formed from a plastic material.

4. Method according to one of the preceding claims, wherein the carrier layer (2) is a film.

5. Method according to one of the preceding claims, wherein the carrier layer (2) is transparent.

6. Method according to one of the preceding claims, wherein the semiconductor components (8) are thin-film semiconductor components.

7. Method according to one of the preceding claims, wherein the layer composite (6) has an active layer sequence (4) for generating electromagnetic radiation.

8. Method according to one of the preceding claims, wherein the layer composite (6) is structured into individual layer stacks (60).

9. Method according to one of the preceding claims, wherein the carrier layer (2) contains a plastic material.

10. Method according to claim 9, wherein
the plastic material contains an epoxy resin, polyethylene terephthalate and/or polymer.

11. Method according to Claim 9 or 10, wherein
the plastic material has curing temperatures in the region of 150°C.

12. Method according to one of the preceding claims, wherein the carrier layer (2) has a thickness that is less than or equal to 100 µm.

13. Method according to one of the preceding claims, wherein the carrier layer (2) contains a thermally conductive material.

14. Method according to one of the preceding claims, wherein the carrier layer (2) contains an electrically insulating material.

15. Method according one of the preceding claims, wherein the carrier layer (2) has at least one electrical conductor path (10a).

16. Method according to one of the claims 1 to 13, wherein the carrier layer (2) has an electrically conductive material.

17. Method according to one of the preceding claims, wherein the layer composite (6) has a first contact metallization (50) on the side facing towards the carrier layer (2).

18. Method according to claim 17, wherein
the contact metallization (50) at least partly reflects the radiation generated by the active layer sequence (4) .

19. Method according to one of the preceding claims, wherein the growth substrate (1) is stripped away by means of a laser stripping method.

20. Method according to claim 1, wherein
the flexible covering layer (11) is partly or completely cured.

21. Thin-film semiconductor component (8) comprising
- a layer stack (60),
- a rigid, self-supporting carrier layer (2) arranged on the layer stack (60),
- a second contact metallization (3) on the layer stack (60), **characterized by**
- a covering layer (11), which is a film and arranged on a side of the layer stack (60) facing away from the carrier layer (2) on the second contact metallization (3) .

22. Thin-film semiconductor component (8) according the preceding claim, wherein
the carrier layer (2) has a base layer (2b) and an adhesion layer (2a), which faces towards the layer stack (60) and which adheres on the layer stack (60).

23. Thin-film semiconductor component (8) according to the preceding claim, wherein
the adhesion layer (2a) is formed from a hot melt adhesive.

24. Thin-film semiconductor component (8) according to one of the two preceding claims, wherein
the base layer (2b) is formed from a plastic material.

25. Thin-film semiconductor component (8) according to one of the claims 21 to 24, wherein
the carrier layer (2) is a film.

26. Thin-film semiconductor component (8) according to one of the claims 21 to 25, wherein
the carrier layer (2) is transparent.

27. Thin-film semiconductor component (8) according to one of the claims 21 to 26, wherein
the layer stack (60) has an active layer stack (40) for generating electromagnetic radiation.

28. Thin-film semiconductor component (8) according to one of the claims 21 to 27, wherein
the carrier layer (2) contains a plastic material.

29. Thin-film semiconductor component (8) according to the preceding claim, wherein
the carrier layer contains an epoxy resin,
polyethylene terephthalate and/or polyimide.

30. Thin-film semiconductor component (8) according to one of the claims 21 to 29, wherein
the carrier layer (2) contains an electrically insulating material.

31. Thin-film semiconductor component (8) according to claim 22 or a claim referring back to Claim 22, wherein
the carrier layer (2) has at least one electrical conductor path (10a).

32. Thin-film semiconductor component (8) according to one of the claims 21 to 29, wherein
the carrier layer (2) contains an electrically conductive material.

33. Thin-film semiconductor component (8) according to the preceding claim, wherein
the carrier layer (2) contains a metal, in particular aluminum, silver, titanium or copper, or an alloy, in particular brass.

34. Thin-film semiconductor component (8) according to claim 32, wherein
the carrier layer (2) contains carbon fibres.

35. Thin-film semiconductor component (8) according to one of the claims 21 to 33, wherein
the carrier layer (2) contains a silicate.

36. Thin-film semiconductor component (8) according to one of the claims 21 to 35, wherein
the carrier layer (2) has a thickness that is less than or equal to 100 µm.

37. Thin-film semiconductor component (8) according to one of the claims 21 to 36, wherein
the covering layer (11) has an optical structure.

38. Thin-film semiconductor component (8) according to one of the claims 21 to 37, wherein
the covering layer (11) contains a converter material.

39. Thin-film semiconductor component (8) according to one of the claims 21 to 38, wherein
a filling layer (17) is arranged between the carrier layer (2) and the covering layer (11).

40. Thin-film semiconductor component (8) according to one of the claims 21 to 39, wherein
the carrier layer (2) and the covering layer (11) form a housing body for the radiation-emitting semiconductor component (8).

41. Thin-film semiconductor component (8) according to one of the claims 21 to 40, wherein
the covering layer (11) is transmissive to the radiation generated by the active layer stack (40).

42. Thin-film semiconductor component (8) according to the preceding claim, wherein
the thin-film semiconductor component (8) is emissive on two sides.

## Revendications

1. Procédé de fabrication de composants semi-conducteur (8) comportant les étapes suivantes :
- Formation d'un composite stratifié (6) contenant un matériau semi-conducteur sur un substrat de croissance (1),
- Application d'une couche de support rigide autoportante (2) sur le composite stratifié (6), dans lequel la couche de support étant générée par application d'une couche flexible sur le composite stratifié (6) et durcissement de la couche flexible pour former une couche rigide autoportante, ou la couche de support (2) présente une couche de base (2b) et une couche adhésive (2a) faisant face au composite stratifié (6) et adhérant à celui-ci (6),
- Retrait du substrat de croissance (1), puis application d'une deuxième métallisation de contact (3) au composite stratifié (6),
- Application d'une couche de revêtement flexible (11), constituée par un film, sur la deuxième métallisation de contact (3), dans lequel
- la couche de support (2) et la couche de revêtement (11) demeurant dans le composant fini.

2. Procédé selon la revendication 1, dans lequel
la couche adhésive (2a) est formée d'un adhésif thermofusible.

3. Procédé selon la revendication 1 ou 2, dans lequel
la couche de base (2b) est formée d'une matière plastique.

4. Procédé selon l'une des revendications précédentes, dans lequel
la couche de support (2) est un film.

5. Procédé selon l'une des revendications précédentes, dans lequel
la couche de support (2) est transparente.

6. Procédé selon l'une des revendications précédentes, dans lequel
les composants semi-conducteurs (8) sont des composants semi-conducteurs à couche mince.

7. Procédé selon l'une des revendications précédentes, dans lequel
le composite stratifié (6) présente une séquence de couches active (4) visant à générer un rayonnement électromagnétique.

8. Procédé selon l'une des revendications précédentes, dans lequel
le composite stratifié (6) est structuré en piles de couches individuelles (60).

9. Procédé selon l'une des revendications précédentes, dans lequel
la couche de support (2) contient une matière plastique.

10. Procédé selon la revendication 9, dans lequel
la matière plastique contient une résine époxy, du polyéthylène téréphtalate et/ou un polymère.

11. Procédé selon la revendication 9 ou 10, dans lequel la matière plastique présente des températures de durcissement de l'ordre de 150°C.

12. Procédé selon l'une des revendications précédentes, dans lequel
la couche de support (2) présente une épaisseur inférieure ou égale à 100 µm.

13. Procédé selon l'une des revendications précédentes, dans lequel
la couche de support (2) contient un matériau thermo-conducteur.

14. Procédé selon l'une des revendications précédentes, dans lequel
la couche de support (2) contient un matériau électro-isolant.

15. Procédé selon l'une des revendications précédentes, dans lequel
la couche de support (2) présente au moins une piste conductrice électrique (10a).

16. Procédé selon l'une des revendications 1 à 13, dans lequel
la couche de support (2) présente un matériau électro-conducteur.

17. Procédé selon l'une des revendications précédentes, dans lequel
le composite stratifié (6) présente une première métallisation de contact (50) faisant face à la couche de support (2).

18. Procédé selon la revendication 17, dans lequel
la métallisation de contact (50) reflète au moins partiellement le rayonnement généré par la séquence de couches active (4).

19. Procédé selon l'une des revendications précédentes, dans lequel
le substrat de croissance (1) est retiré au moyen d'un procédé de retrait au laser.

20. Procédé selon la revendication 1, dans lequel
la couche de revêtement flexible (11) est partiellement ou complètement durcie.

21. Composant semi-conducteur à couche mince (8) avec
- une pile de couches (60),
- une couche de support rigide autoportante (2) disposée sur la pile de couches (60),
- une deuxième métallisation de contact (3) sur la pile de couches (60), **caractérisé par**
- une couche de revêtement (11), qui est un film et disposée sur un côté de la pile de couches (60) opposé à la couche de support (2) sur la deuxième métallisation de contact (3).

22. Composant semi-conducteur à couche mince (8) selon la revendication précédente, dans lequel
la couche de support (2) présente une couche de base (2b) et une couche adhésive (2a) faisant face à la pile de couches (60) et adhérant à celle-ci (60).

23. Composant semi-conducteur à couche mince (8) selon la revendication précédente, dans lequel
la couche adhésive (2a) est formée d'un adhésif thermofusible.

24. Composant semi-conducteur à couche mince (8) selon l'une des deux revendications précédentes, dans lequel
la couche de base (2b) est formée d'une matière plastique.

25. Composant semi-conducteur à couche mince (8) selon l'une des revendications 21 à 24, dans lequel
la couche de support (2) est un film.

26. Composant semi-conducteur à couche mince selon l'une des revendications 21 à 25, dans lequel
la couche de support (2) est transparente.

27. Composant semi-conducteur à couche mince (8) selon l'une des revendications 21 à 26, dans lequel
la pile de couches (60) présente une pile de couches active (40) visant à générer un rayonnement électromagnétique.

28. Composant semi-conducteur à couche mince selon l'une des revendications 21 à 27, dans lequel
la couche de support (2) contient une matière plastique.

29. Composant semi-conducteur à couche mince (8) selon la revendication précédente, dans lequel
la couche de support contient une résine époxy, du polyéthylène téréphtalate et/ou un polyimide.

30. Composant semi-conducteur à couche mince selon l'une des revendications 21 à 29, dans lequel
la couche de support (2) contient un matériau électro-isolant.

31. Composant semi-conducteur à couche mince (8) selon la revendication 22 ou une revendication basée sur la revendication 22, dans lequel
la couche de support (2) présente au moins une piste conductrice électrique (10a).

32. Composant semi-conducteur à couche mince (8) selon l'une des revendications 21 à 29, dans lequel
la couche de support (2) contient un matériau électro-conducteur.

33. Composant semi-conducteur à couche mince (8) selon la revendication précédente, dans lequel
la couche de support (2) contient un métal, notamment de l'aluminium, de l'argent, du titane ou du cuivre, ou un alliage, notamment du laiton.

34. Composant semi-conducteur à couche mince (8) selon la revendication 32, dans lequel
la couche de support (2) contient des fibres de carbone.

35. Composant semi-conducteur à couche mince selon l'une des revendications 21 à 33, dans lequel
la couche de support (2) contient un silicate.

36. Composant semi-conducteur à couche mince selon l'une des revendications 21 à 35, dans lequel
la couche de support (2) présente une épaisseur inférieure ou égale à 100 µm.

37. Composant semi-conducteur à couche mince (8) selon l'une des revendications 21 à 36, dans lequel
la couche de revêtement (11) présente une structure optique.

38. Composant semi-conducteur à couche mince (8) selon l'une des revendications 21 à 37, dans lequel
la couche de revêtement (11) contient un matériau convertisseur.

39. Composant semi-conducteur à couche mince selon l'une des revendications 21 à 38, dans lequel
une couche de remplissage (17) est disposée entre la couche de support (2) et la couche de revêtement (11).

40. Composant semi-conducteur à couche mince selon l'une des revendications 21 à 39, dans lequel
la couche de support (2) et la couche de revêtement (11) forment un corps de boîtier pour le composant semi-conducteur émetteur de rayonnement (8).

41. Composant semi-conducteur à couche mince selon l'une des revendications 21 à 40, dans lequel
la couche de revêtement (11) est perméable au rayonnement généré par la pile de couches active (40).

42. Composant semi-conducteur à couche mince (8) selon la revendication précédente, dans lequel
le composant semi-conducteur à couche mince (8) est émetteur sur deux côtés.
